# EUROPEAN PATENT SPECIFICATION

(11) **EP 2 794 951 B1**
(45) Date of publication and mention of the grant of the patent: **06.03.2019**
(21) Application number: 12812866.7
(22) Date of filing: 21.12.2012
(51) Int. Cl.: C23C 28/02, C23C 14/16, C23C 14/02

(54) **SUBSTRATE WITH A DOUBLE LAYERED COATING**
SUBSTRAT MIT DOPPELSCHICHTIGER BESCHICHTUNG
SUBSTRAT AVEC DOUBLE COUCHE STRATIFIÉE

(30) Priority: 23.12.2011 EP 11010190
(43) Date of publication of application: 29.10.2014
(73) Proprietor: Tata Steel Nederland Technology B.V., 1951 JZ Velsen-Noord (NL)
(72) Inventor: ZOESTBERGEN, Edzo, NL-1970 CA Ijmuiden (NL); MAALMAN, Theodorus Franciscus Jozef, NL-1970 CA Ijmuiden (NL); LANGKRUIS, Jörgen van de, NL-1970 CA Ijmuiden (NL); GOODENOUGH, Mark Robert, NL-1970 CA Ijmuiden (NL)
(74) Representative: Blauw, Frans Gerard
(86) International application number: PCT/EP2012/005333
(87) International publication number: WO 2013/091889

(56) References cited:
- WO-A1-02/14573
- GB-A- 1 235 412
- US-A- 5 135 817

## Description

The disclosure relates to a steel substrate provided with a Zn-Mg alloy coating layer and Zn layer between the substrate and the coating layer and a method to manufacture such a coated substrate.

Steel substrates, more in particular steel sheets, with a Zn-Mg coating layer are known in the art, see for instance EP0730045. Such coating layers are applied to get good corrosion resistance and at the same time provide good adhesion for finishing coatings such as paint.

Such coated substrates and more in particular steel sheets are often used in applications where the sheets have to be formed mechanically to a final part, for instance for automotive parts or parts for various household or industrial products. In most applications not only good corrosion resistance is required, but also a good adhesion of the coating to the substrate. The last property is important in mechanical forming operations of metal sheet like deep drawing and stamping, and during crash loading of a coated car part, to prevent that the coating detaches from the substrate and causes visible defects or compromises structure integrity.

Further the coating should have a relatively low friction coefficient, which does not increase or does not increase significantly during forming, such that galling, that is transfer of material between coated sheet surface and forming tool, is prevented as much as possible even with multiple forming steps.

It is an objective of the present invention to provide a substrate with a triple layered coating that has good corrosion resistance.

It is another objective of the present invention to provide a substrate with a triple layered coating with good adhesion between the coating and the substrate.

It is another objective of the present invention to provide a substrate with a triple layered coating that is sufficiently ductile to allow a high degree of deformation.

It is still another objective of the present invention to provide a substrate with a triple layered coating that has a relatively low friction coefficient.

It is still another objective of the present invention to provide a substrate with a triple layered coating that allows multiple forming steps with no or only minimal galling occurring.

According to a first aspect of the disclosure one or more of the above objectives are realized by providing a steel substrate with at least at one side a Zn-Mg coating layer and an intermediate layer in between the substrate and the Zn-Mg coating layer, wherein the weight of the Mg-content of the coating layer is maximally 2.6 g/m² and wherein the intermediate layer has a maximum thickness of 4.0 µm.

It was found that in order to have good adhesion properties between the substrate and the coating, the coating should not only comprise a coating layer and an intermediate layer between the coating layer and the substrate, but that the thickness of the intermediate layer and the Mg-content of the coating layer should also be within certain limits.

It was further found that to have optimal adhesion between coating and substrate, for certain thickness ranges of the intermediate layer the maximum Mg-content of the coating layer is different than for other thickness ranges of the intermediate layer. To have optimal adhesion between coating and substrate it was found that the weight of the Mg-content of the coating layer is dependent on the thickness (d) of the intermediate layer according to:

| | |
|---|---|
| 0.35 < d ≤ 1.5 µm: | Mg-weight in coating layer ≤ 2.6 g/m² |
| 1.5 < d ≤ 2.7 µm: | Mg-weight in coating layer ≤ 2.2 g/m² |
| 2.7 < d ≤ 4.0 µm: | Mg-weight in coating layer ≤ 1.7 g/m² |

According to a further aspect of the disclosure it is provided that the largest thickness of the intermediate layer is limited to d ≤ 4.0 µm, since a thickness of the intermediate layer exceeding this upper limit means extra costs while at the same time it does not lead to clearly noticeable further improvement of the adhesion between the coating and the substrate.

In the lower thickness range of the intermediate layer there is a certain lower limit to be able to guarantee good adhesion properties between the substrate and the intermediate layer. Although a number of tests showed that even with a thickness of 0.1 µm for the intermediate layer good results can be obtained, a greater thickness of the intermediate layer is preferred to prevent migration of Mg through the Zn layer to the substrate interface. Such Mg-migration could considerably degrade the adhesion of the coating to the substrate. For that reason preferably a thickness for the lower limit for the intermediate layer of 0.35 µm is maintained. The lower limit of the thickness of the intermediate layer is of importance for the adhesion between the intermediate layer and the coating layer.

According to a further aspect of the invention the intermediate layer is a Zn layer in order to have good corrosion resistance as well as good adhesion.

According to still a further aspect of the invention a Zn top layer is provided on the coating layer with a Mg-content of ≤ 0.5wt.%. Such a top layer may be provided in order to have good resistance against darkening and/or staining effects due to contact with a moist environment.

The intermediate layer can be applied by different methods such as electro galvanising (EZ), hot dip galvanising (HDG), or physical vapour deposition (PVD). Since it is more cost-effective to use EZ for applying the intermediate layer and the relevant properties of the resulting intermediate layer are within the claimed ranges, this method is a good alternative for PVD.

According to another aspect of the invention the Zn and Mg of the coating layer are applied simultaneously by PVD, resulting in a microstructure comprising a Mg2Zn11 phase and a Zn phase with Mg dissolved in solid solution. By applying Zn and Mg simultaneously by means of PVD even at higher Mg concentrations a Mg2Zn11 phase is obtained in the coating layer rather than a MgZn2 phase. The Mg2Znll phase is richer in Zn and provides better formability and also a better adhesion with the intermediate layer, because the MgZn2 phase is a hexagonal Laves phase, belonging to the brittle family of intermetallics, see for instance P. Paufler, Early work on Laves phases in East Germany, Intermetallics (2011), Volume 19, p599-612. Up to a certain limit the coating layer may also comprise a MgZn2 phase in addition to or replacing part of the Mg2Zn1 1 phase, without noticeably effecting the ductility of the coating layer.

According to still another aspect of the invention the Zn top is applied by PVD. By applying the top layer by PVD the time between deposition of the coating layer and the top layer is minimised, therewith preventing oxidation of the coating layer or considerably reducing the degree of oxidation of the coating layer. This is beneficial for the adhesion of the top layer to the coating layer.

The invention is disclosed in claim 1 and provides a method for manufacturing a steel substrate with an intermediate Zn layer, a Zn-Mg coating layer and a Zn top layer.

It is further provided that the intermediate Zn layer is deposited by EZ, HDG or PVD.

There are PVD techniques using an alloy melt, such as direct induction PVD, electro-magnetic levitation (EML) PVD and jet vapour deposition (JET-PVD). The alloy can also be vaporised from a solid target with magnetron sputtering PVD. With each of these PVD techniques the PVD-related advantages for adhesion can be achieved.

The method further comprises the step of plasma cleaning the substrate by plasma cleaning before applying the intermediate layer.

Alternatively to plasma cleaning the substrate can also be deoxidised with a reduction furnace or cleaned in a pickling line before entering the vacuum chamber. These cleaning and/or deoxidising steps can also be combined with plasma cleaning in the vacuum chamber, after the substrate enters the vacuum chamber.

The invention will be further explained referring to the examples and figures below, in which:
- Fig. 1: shows schematically a PVD process line to apply a Zn-Mg alloy coating on a strip;
- Fig. 2a: shows a diagram with the time till red rust formation with phosphated and non-phosphated samples;
- Fig. 2b: shows a diagram with the average depth of the five deepest pits in the phosphated samples;
- Fig. 3: shows a diagram with results of a V-bend powdering test;
- Fig. 4: shows the results of a linear friction test, and
- Fig. 5: shows the results of a crash adhesion test.

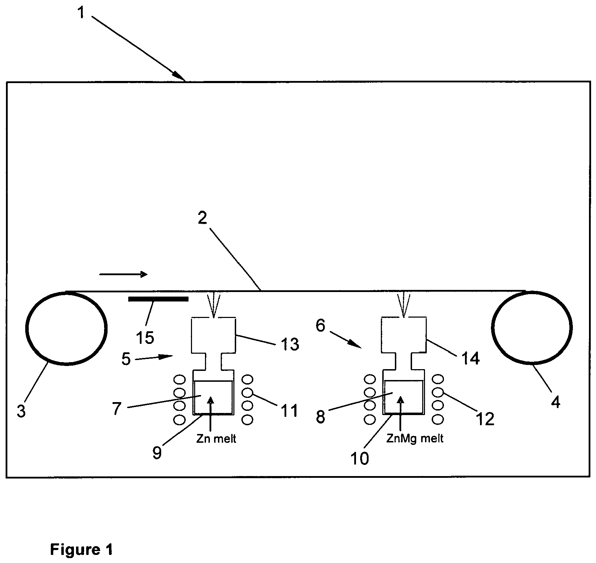

Fig. 1 shows schematically the direct induction PVD process line used for coating a steel sheet with a coating layer. In a vacuum chamber 1 a steel sheet 2 is decoiled from decoiler 3 and moved to a coiler 4 thereby passing a first PVD device 5 and a second PVD device 6. The PVD devices 5 and 6 each comprise a metal or metal alloy melt 7, 8 in a crucible 9, 10, an induction coil 11, 12 to melt and evaporate the metal or metal alloy in the crucible 9, 10 and a vapour distribution box 13, 14 to direct the vapour to the steel sheet 2. A plasma cleaning device 15 is provided to clean the steel sheet before deposition of a coating layer takes place.

In the shown configuration the first PVD device 5 is used to heat and evaporate Zn in the crucible 9 and deposit a Zn layer on sheet 2 and the second PVD device 6 to heat, evaporate Zn and Mg in crucible 10 and deposit a Zn-Mg layer on top of the already deposited Zn layer. The thickness of the layers is regulated by varying the speed with which the sheet is moved past the vapour distribution boxes 13 and 14.

In the shown PVD process line the decoiler 3 and coiler 4 are both placed within the vacuum chamber since the process line is used for experimental purposes. In an industrial PVD process line the decoiler 3 and coiler 4 will both be placed outside the vacuum chamber with vacuum locks through which the sheet 2 is moved into and out of the vacuum chamber.

### EXAMPLE 1

An interferritic steel sheet was used as a parent sheet, which was degreased and inserted as a coil in the vacuum chamber of a direct induction pilot line for continuous PVD. In the vacuum chamber the coil is uncoiled, plasma cleaned with Argon gas for oxide removal with a magnetron sputtering unit until the strip temperature was approximately 160 °C, coated on one side, firstly with a Zn-layer and then with a Zn-Mg layer, using physical vapour deposition and finally coiled again.

The vapour deposition took place by heating of the Zn and Zn-Mg melt in nonconductive ceramic crucibles to a temperature range of 615-675 °C and 720-780 °C respectively, using induction coils. The metal vapour and the alloy vapour were each guided into a vapour distribution box (VDB) with an average temperature of 1000 °C. The vapour is deposited onto the strip via nozzles of the VDB. The Zinc layer is deposited first, followed by a Zn-Mg coating layer. The nozzle area of the VDB nozzles are dimensioned to achieve a choking condition, ensuring that the vapour leaves the VDB with sonic speed. The typical pressure in the vacuum chamber was in the range 10⁻³ - 10⁻⁵ mbar. After the vapour deposition of the coating layer the typical strip temperature was approximately 220 °C. The melt temperatures and strip speed were varied to control the layer thicknesses. The production process of the coatings is schematically depicted in Figure 1.

After coating coupons were taken from the coated coils for a variety of tests, listed below. The testing results have been compared to electro-galvanised (EG), galvanised (GI), galvanealed (GA) and hot dip ZnMgAl coating (MZ) references. The Mg concentration in the coatings was measured using wet chemical analysis.

The coatings according to the present invention are coded as follows: Zi+ZMj_k, with "i" the Zn layer thickness in micrometer and "j", "k" the Mg concentration and layer thickness in micrometer of the Zn-Mg layer, respectively.

The produced single-sided coatings with their coating weights are given in Table 1. Details about the double-sided references are given in Table 2. It is clear that the invention coatings containing Mg are much lighter than the references. The higher the percentage of Mg in the coating, the lighter the coating.

The following product tests were carried out:
- Perforation corrosion test with a crevice configuration to simulate hem-flange design (Volvo STD 423-0014)
- V-bend test for powdering (Honda C502-99)
- Linear friction test for galling and determining the friction coefficient
- Crash adhesion test (BMW AA-M223)

In the industry car panels are phosphated before painting for improved paint adhesion. This phosphating treatment may influence the crevice corrosion behaviour, for instance at a hemmed joint in the car, where phosphating is incomplete. This is demonstrated with the accelerated perforation corrosion testing results reported here. With the perforation corrosion test all samples were phosphated with Bonderite and electro-coated with electro-coat type PPG 771. Half of the samples were prepared with phosphate in the crevice area, the other half without phosphate by masking the crevice area during phosphating.

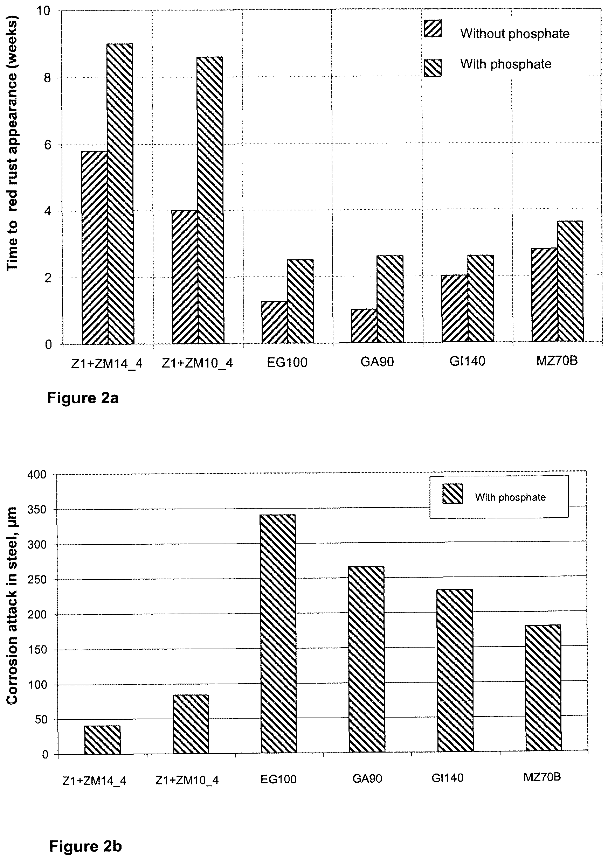

In Figure 2a, b the results of the perforation corrosion tests are given. The invention coatings are compared to the references, both with and without phosphating the crevice area before corrosion testing.

The results clearly show that the Zn+ZnMg-PVD coatings have significantly longer time to first formation of red rust and significantly less deep pits than the references, while at the same time the coating weight is significantly less. The effect is even more pronounced with phosphate in the crevice area.

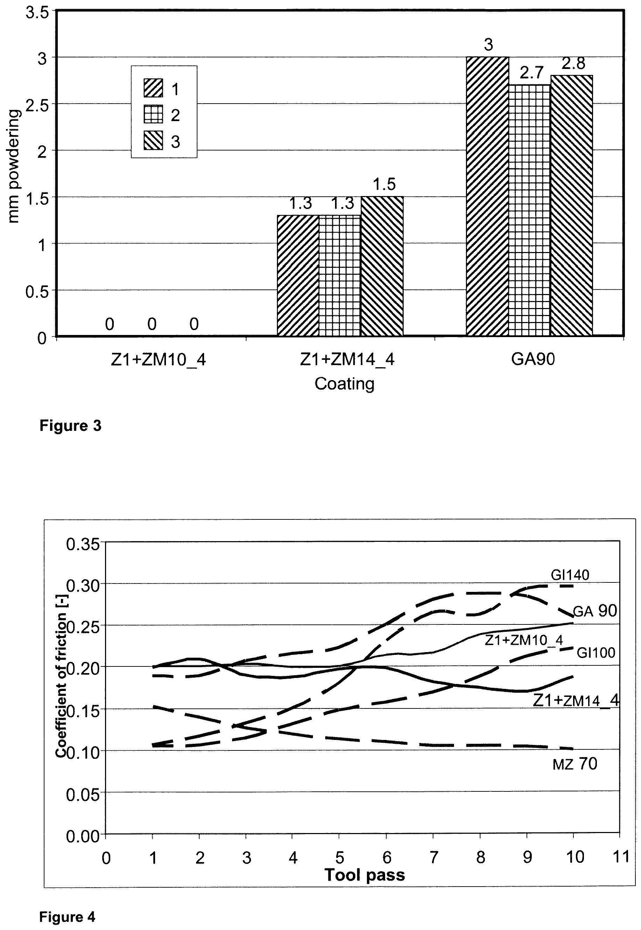

In Figure 3 the results of the V-bend powdering tests are shown. The test was carried out in triplicate. The figure shows that the coatings according to the invention have better powdering resistance than the GA90 reference and the powdering response can be further optimised by decreasing the Mg content.

With the linear friction test samples of 50mm width and 300mm length were pulled at a speed of 0.33 mm/s between a set of tools pushed together with a force of 2 kN. Figure 4 shows the linear friction data of the coatings according to the invention, compared to the references. Due to the thinner gauge of the invention material with regard to the thickness of the references, two samples of the invention material were placed with the backsides against each other for better load distribution. The thicker the material the better it will withstand plastic deformation imposed on it by forming tools, therefore the provided data for the coatings according to the invention are believed to be an underestimate of the performance for thicker gauges, closer to the reference GA90.

It is clear that the friction coefficient stays constant for significantly more passes than with the zinc-only coatings and competes well with galvanealed coating GA90. Only the MZ70 coating performs better. The galling behaviour of the Z1+ZM14_4 coating was excellent with no flaking and galling at all, the galling of Z1+ZM10_4 coating was still good and is expected to be better for thicker gauges.

The adhesion test (BMW AA-M223) is developed for crash circumstances relevant for forming processes to represent zinc adhesion behaviour under crash like conditions. An adhesively bonded joint should preferably break in the adhesive, not between the adhesive and the zinc and certainly not between the zinc and the steel. The test was originally developed for advanced high strength steels (AHSS), hence it was adapted for thin gauges in the following way: the thin samples were glued onto a strip of higher gauge (1 mm) by an adhesive (DP490, a two component epoxy adhesive) that cures at room temperature.

Strips of 200 x 30 mm were cut (in threefold) and ultrasonically degreased in acetone to remove oil. A line of adhesive Betamate 1496V of DOW Chemical of at least 150 mm length, about 4-5 mm thick and at least 10 mm wide is applied. Curing of the adhesive takes place in a furnace kept at 175 °C during 30 minutes. The strip is bended till 90° with the glue at the exterior bend in a special bending machine around a tool with a radius of 1 mm. The glue breaks in this process. Any delamination of the adhesive or of the zinc coating is observed. If the coating is substantially or completely removed from the substrate then the coating is qualified as not-OK.

The results for GA90 and Z1+ZM14_4 (corresponding Mg weight in the coating layer is 2.8 g/m^2) were NOK. The results for Z1+ZM10_4 (corresponding Mg weight in the coating layer is 2.2 g/m^2) and EG100 were OK. This shows that the invention coatings can withstand this severe adhesion test when the Mg content is 10 wt.% or lower. More details on the exact boundary for a successful test are provided in the next example.

### EXAMPLE 2

The same parent sheet and production process was used as in the previous example to produce single sided coating consisting of a Zn coating layer on the parent sheet and a Zn-Mg coating layer on top of the Zn coating layer. The thickness of the Zn layer is in the range of 0.2 - 4 micrometer and the total weight of the Zn-Mg coating layer in the range of 1.9-26 g/m². The Mg weight in the Zn-Mg coating layer of the coating was in the range of 0-4.0 g/m².

After coating coupons were taken from the coated coils for crash adhesion testing according to BMW AA-M223. It is noted that this test is a severe test for the coating adhesion performance of the coated product.

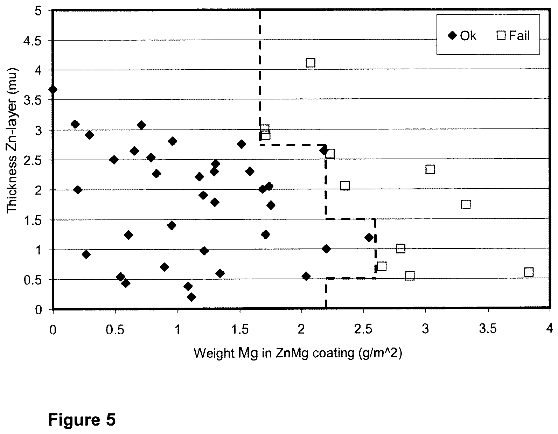

The results of the crash adhesion tests have been summarised in Figure 5. The figure shows the regime of combinations of Zn-coating layer thickness and the Mg weight in the Zn-Mg coating layer, for which the crash test is successfully passed. The figure shows that the allowable weight of Mg in the topcoat depends on the Zn-layer thickness and that ranges can be defined in which adhesion is superior over higher Mg weight contents in the top coat.

**Table 1 Produced PVD invention coatings, coatings are single-sided.**

| Code | Mg in crucible (wt.%) | ZnMg Melt temperature (°C) | Overall coating thickness (micrometer) | Coating weight, one side (g/m²) | Mg in ZnMg layer (wt.%) | Mg weight (g/m²) |
|---|---|---|---|---|---|---|
| Z1+ZM10_4 | 9.4 | 722 | 5.0 | 30.5 | 10 | 2.2 |
| Z1+ZM14_4 | 12.5 | 780 | 5.0 | 30 | 14 | 2.8 |

**Table 2 Reference coating systems (double-sided), numbers indicate coating weight of both sides added together**

| Name | Gauge (mm) | Single side coating weight (g/m²) | Al in coating (wt.%) | Mg in coating (wt.%) | Fe in coating (wt.%) | Mg weight (per side) [g/m²] |
|---|---|---|---|---|---|---|
| EG100 | 0.80 | 33 | < 0.01 | <0.01 | 0.16 | 0 |
| GI120 | 0.80 | 59 | 0.4 | <0.01 | 0.3 | 0 |
| GA90 | 0.69 | 43 | 0.3 | <0.01 | 10 | 0 |
| MZ70 | 0.70 | 36 | 1.9 | 1.8 | 0.3 | 0.65 |

## Claims

1. Method for manufacturing a steel substrate with an intermediate layer, a Zn-Mg coating layer and a top layer, wherein at least at one side a Zn-Mg coating layer, an intermediate layer between the substrate and the Zn-Mg coating layer and a top layer are provided, **characterised in that** the weight of the Mg-content of the coating layer is maximally 2.6 g/m² , wherein the intermediate layer has a maximum thickness of 4.0 µm and wherein the weight of the Mg-content of the coating layer is dependent on the thickness (d) of the intermediate layer according to:
| | |
|---|---|
| 0.35 ≤ d ≤ 1.5 µm: | Mg-weight in coating layer ≤ 2.6 g/m² |
| 1.5 < d ≤ 2.7 µm: | Mg-weight in coating layer ≤ 2.2 g/m² |
| 2.7 < d ≤ 4.0 µm: | Mg-weight in coating layer ≤ 1.7 g/m², |
wherein Zn and Mg of the coating layer is applied simultaneously by PVD evaporation from a single crucible (10) holding an alloy melt of Zn and Mg, resulting in a microstructure comprising a Mg2Znl 1 phase and a Zn phase with Mg dissolved in solid solution, wherein the intermediate layer is a Zn layer and wherein a Zn top layer is applied by heating and evaporating Zn and depositing Zn on the Zn-Mg coating layer.

2. Method according to claim 1, wherein the intermediate layer has been applied either by electro galvanising (EZ), hot dip galvanising (HDG) or physical vapour deposition (PVD).

3. Method according to claim 1 or 2, wherein the substrate is cleaned by plasma cleaning before applying the intermediate layer.

## Patentansprüche

1. Verfahren zum Herstellen eines Stahlsubstrats mit einer Zwischenlage, einer Zn-Mg-Beschichtungslage und einer Decklage, wobei mindestens bei einer Seite eine Zn-Mg-Beschichtungslage, eine Zwischenlage zwischen dem Substrat und der Zn-Mg-Beschichtungslage und eine Decklage bereitgestellt werden, **dadurch gekennzeichnet, dass** das Gewicht des Mg-Gehalts der Beschichtungslage maximal 2,6 g/m² beträgt, wobei die Zwischenlage eine Maximaldicke von 4,0 µm aufweist und wobei das Gewicht des Mg-Gehalts der Beschichtungslage von der Dicke (d) der Zwischenlage abhängig ist gemäß:
| | |
|---|---|
| 0,35 < d < 1,5 µm: | Mg-Gewicht in der Beschichtungslage < 2,6 g/m² |
| 1,5 < d < 2,7 µm: | Mg-Gewicht in der Beschichtungslage < 2,2 g/m² |
| 2,7 < d < 4,0 µm: | Mg-Gewicht in der Beschichtungslage < 1,7 g/m², |
wobei Zn und Mg der Beschichtungslage gleichzeitig durch PVD-Verdampfung aus einem einzelnen Schmelztiegel (10) aufgebracht wird, der eine Legierungsschmelze von Zn und Mg bereithält, was eine Mikrostruktur ergibt, die eine Mg2Znll-Phase und eine Zn-Phase mit in Feststofflösung aufgelöstem Mg umfasst, wobei die Zwischenlage aus einer Zn-Lage besteht und wobei eine Zn-Decklage durch Erhitzen und Verdampfen von Zn und Abscheiden von Zn auf der Zn-Mg-Beschichtungslage aufgebracht wird.

2. Verfahren nach Anspruch 1, wobei die Zwischenlage entweder durch Elektroverzinkung (EZ), Feuerverzinkung (HDG) oder physikalische Gasphasenabscheidung (PVD) aufgebracht wurde.

3. Verfahren nach Anspruch 1 oder 2, wobei das Substrat vor dem Aufbringen der Zwischenlage durch Plasmareinigen gereinigt wird.

## Revendications

1. Méthode de fabrication d'un substrat d'acier possédant une couche intermédiaire, une couche de revêtement au Zn-Mg, et une couche supérieure, étant pratiquées, au moins sur un côté une couche de revêtement au Zn-Mg, une couche intermédiaire entre le substrat et la couche de revêtement au Zn-Mg, et une couche supérieure, **caractérisée en ce que** le poids maximum de la teneur en Mg de la couche de revêtement est 2,6 g/m², l'épaisseur maximum de la couche intermédiaire étant 4,0 µm, et le poids de la teneur en Mg de la couche de revêtement étant tributaire de l'épaisseur (d) de la couche intermédiaire d'après :
| | |
|---|---|
| 0,35 ≤ d ≤ 1,5 µm: | poids de Mg dans la couche de revêtement ≤ 2,6 g/m² |
| 1,5 < d ≤ 2,7 µm: | poids de Mg dans la couche de revêtement ≤ 2,2 g/m² |
| 2,7 < d ≤ 4,0 µm: | poids de Mg dans la couche de revêtement ≤ 1,7 g/m², |
les Zn et Mg de la couche de revêtement étant appliqués simultanément par évaporation de PVD d'un creuset unique (10) contenant une coulée d'alliage de Zn et Mg, donnant lieu à une microstructure comprenant une phase de Mg2Znl 1 et une phase de Zn avec du Mg dissous dans une solution solide, la couche intermédiaire étant une couche de Zn et une couche supérieure de Zn étant appliquée par chauffage et évaporation de Zn, et le dépôt de Zn sur la couche de revêtement de Zn-Mg.

2. Méthode selon la revendication 1, la couche intermédiaire ayant été appliquée soit par électro-zingage (EZ), galvanisation par immersion à chaud (HDG), ou dépôt physique en phase vapeur (PVD).

3. Méthode selon la revendication 1 ou 2, le substrat étant nettoyé par nettoyage au plasma préalablement à l'application de la couche intermédiaire.
